(19)

Europäisches
Patentamt
European
Patent Office
Office européen
des brevets

(11) **EP 4 507 454 A1**

(12) **EUROPEAN PATENT APPLICATION**

(43) Date of publication:
**12.02.2025 Bulletin 2025/07**

(21) Application number: **24151391.0**

(22) Date of filing: **11.01.2024**

(51) International Patent Classification (IPC):
**H05B 6/06** $^{(2006.01)}$

(52) Cooperative Patent Classification (CPC):
**H05B 6/062**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **10.08.2023 CN 202311006469**

(71) Applicant: **Delta Electronics, Inc.
Taoyuan City 33370 (TW)**

(72) Inventors:
• **Huang, Ming-Shi
Taoyuan City 32063 (TW)**

• **Li, Zheng-Feng
Taoyuan City 32063 (TW)**
• **Hu, Jhih-Cheng
Taoyuan City 32063 (TW)**
• **Chen, Yi-Min
Taoyuan City 32063 (TW)**
• **Lin, Chun-Wei
Taoyuan City 32063 (TW)**

(74) Representative: **Uexküll & Stolberg
Partnerschaft von
Patent- und Rechtsanwälten mbB
Beselerstraße 4
22607 Hamburg (DE)**

Remarks:
Amended claims in accordance with Rule 137(2)
EPC.

(54) **HEATING DEVICE AND DETECTING METHOD THEREOF**

(57)     A heating device (1) includes a resonant circuit (22), a detection unit (3) and a control unit (4). The resonant circuit (22) includes an inverter circuit (20) and a resonant tank (21). The inverter circuit (20) provides a resonant tank current ($I_r$) and a resonant tank voltage ($V_r$). The resonant tank (21) includes a heating coil (210), a resonant tank capacitor ($C_r$), a resonant tank equivalent inductor ($L_{est}$) and a resonant tank equivalent resistor ($R_{est}$). The detection unit (3) calculates an inductance of the resonant tank equivalent inductor ($L_{est}$) according to a capacitance of the resonant tank capacitor ($C_r$), a resonant period ($T$) and a first expression. The detection unit (3) calculates a resistance of the resonant tank equivalent resistor ($R_{est}$) according to the inductance of the resonant tank equivalent inductor ($L_{est}$), a time change value ($\Delta t$), a reference voltage value ($V_1$), a negative peak voltage value ($V_{np}$) and a second expression.

FIG. 1B

EP 4 507 454 A1

**Description**

FIELD OF THE INVENTION

The present disclosure relates to a heating device, and more particularly to a heating device with a resonant tank and a detecting method thereof.

BACKGROUND OF THE INVENTION

Nowadays, a variety of heating devices such as gas stoves, infrared oven, microwave oven and electric stove are widely used to cook food. Different heating devices have their advantages or disadvantages. Depending on the food to be cooked, a desired heating device is selected.

Take an induction cooking stove as an example of the heating device. When a current flows through the induction coil (or a heating coil) of the induction cooking stove, electromagnetic induction is performed to produce eddy current, thereby heating a foodstuff container. By adjusting electricity to the induction coil, the heat quantity for heating the foodstuff container is determined. Depending on the location of the foodstuff container relative to the induction coil and the material of the foodstuff container, the heat quantity for heating the foodstuff container by the induction coil and the operating condition and the current magnitude of the induction coil are varied. Generally, in case that the locations of the foodstuff containers or the materials of the foodstuff containers are different, different equivalent parameters are sensed by a resonant tank of the conventional induction cooking stove. In accordance with a conventional technology, the resonant tank equivalent resistance and the resonant tank equivalent inductance are calculated according to the resonant tank voltage, the resonant tank current and the phase difference between the resonant tank voltage and the resonant tank current. According to the calculation results of the resonant tank equivalent resistance and the resonant tank equivalent inductance, the electric power of the induction coil is adjusted. However, the conventional technology still has some drawbacks. For example, the conventional heating device needs to be additionally equipped with a voltage detection circuit and a current detection circuit. Consequently, the circuitry topology of the conventional heating device is complicated, and the fabricating cost is high.

Therefore, there is a need of providing an improved heating device and a suitable detecting method in order to overcome the drawbacks of the conventional technologies.

SUMMARY OF THE INVENTION

The present disclosure provides a heating device and a detecting method for the heating device. The heating device includes a resonant tank. The main working principle of the present disclosure is based on the natural response characteristics of the resonant tank in the negative half cycle. The inductance of the resonant tank equivalent inductor and the resistance of the resonant tank equivalent resistor are calculated according to the voltage information of the resonant tank. In other words, the current detection circuit can be omitted. When compared with the conventional heating device, the detection circuit of the heating device of the present disclosure is simplified and the cost is reduced.

In accordance with an aspect of present disclosure, a heating device is provided. The heating device includes a resonant circuit, a detection unit and a control unit. The resonant circuit includes an inverter circuit and a resonant tank. The inverter circuit provides a resonant tank current and a resonant tank voltage. The resonant tank includes a heating coil, a resonant tank capacitor, a resonant tank equivalent inductor and a resonant tank equivalent resistor. The detection unit is electrically coupled with the resonant circuit. The detection unit detects a capacitor voltage of the resonant tank capacitor to acquire a reference voltage value, a first zero-crossing time point, a second zero-crossing time point, a time change value, a resonant period and a negative peak current value. The reference voltage value is a voltage value of the capacitor voltage when the resonant tank voltage is zero, the time change value is a time length between a time point when the resonant tank voltage is zero and the first zero-crossing time point. The resonant period is defined according to the first zero-crossing time point and the second zero-crossing time point. The control unit controls the inverter circuit to output the resonant tank current and the resonant tank voltage. Consequently, a heating power of the heating coil is adjustable. The detection unit calculates an inductance of the resonant tank equivalent inductor according to a capacitance of the resonant tank capacitor, the resonant period and a first expression. The detection unit calculates a resistance of the resonant tank equivalent resistor according to the inductance of the resonant tank equivalent inductor, the time change value, the resonant period, the reference voltage value, the negative peak voltage value and a second expression. The control unit controls the heating power of the heating coil according to the inductance of the resonant tank equivalent inductor and the resistance of the resonant tank equivalent resistor. The first expression is expressed as a following mathematic formula:

$$L_{est} = \left(\frac{T}{2\pi\sqrt{C_r}}\right)^2 \quad,$$

wherein $L_{est}$ is the inductance of the resonant tank equivalent inductor, $C_r$ is the capacitance of the resonant tank capacitor, and T is the resonant period, and the second expression is expressed as a following mathematic formula:

$$R_{est} = \frac{2L_{est}}{\Delta t + \frac{3T}{4}} ln\left(\frac{V_1}{V_{np}} \frac{1}{sin\left(\frac{\Delta t}{T} 2\pi\right)}\right) \quad,$$

wherein $R_{est}$ is the resistance of the resonant tank equivalent resistor, $V_1$ is the reference voltage value, $\Delta t$ is the time change value, and $V_{np}$ is the negative peak voltage value.

In accordance with another aspect of present disclosure, a detecting method for a detection unit of a heating device is provided. The heating device further includes a resonant circuit. The resonant circuit includes an inverter circuit and a resonant tank. The inverter circuit provides a resonant tank current and a resonant tank voltage. The resonant tank includes a heating coil, a resonant tank capacitor, a resonant tank equivalent inductor and a resonant tank equivalent resistor. The detecting method includes the steps of:

(a) detecting a capacitor voltage of the resonant tank capacitor to acquire a reference voltage value, a first zero-crossing time point, a second zero-crossing time point, a time change value, a resonant period, a negative peak voltage value and a positive peak voltage value, wherein the reference voltage value is a voltage value of the capacitor voltage when the resonant tank voltage is zero, the time change value is a time length between a time point when the resonant tank voltage is zero and the first zero-crossing time point, and the resonant period is defined according to the first zero-crossing time point and the second zero-crossing time point;

(b) calculating an inductance of the resonant tank equivalent inductor according to a capacitance of the resonant tank capacitor, the resonant period and a first expression, wherein the first expression is expressed as a following mathematic formula:

$$L_{est} = \left(\frac{T}{2\pi\sqrt{C_r}}\right)^2 \quad,$$

where $L_{est}$ is the inductance of the resonant tank equivalent inductor, $C_r$ is the capacitance of the resonant tank capacitor, and T is the resonant period;

(c) calculating a resistance of the resonant tank equivalent resistor according to the inductance of the resonant tank equivalent inductor, the time change value, the resonant period, the reference voltage value, the negative peak voltage value, the positive peak voltage value and one of a second expression, a third expression and a fourth expression, wherein the second expression is expressed as a following mathematic formula:

$$R_{est} = \frac{2L_{est}}{\Delta t + \frac{3T}{4}} ln\left(\frac{V_1}{V_{np}} \frac{1}{sin\left(\frac{\Delta t}{T} 2\pi\right)}\right) \quad,$$

the third expression is expressed as a following mathematic formula:

$$R_{est} = \frac{2L_{est}}{\Delta t + \frac{T}{4}} ln\left(\frac{-V_1}{V_{pk}} \frac{1}{sin\left(\frac{\Delta t}{T} 2\pi\right)}\right)$$

the fourth expression is expressed as a following mathematic formula:

$$R_{est} = \frac{4L_{est}}{T} ln\left(\frac{-V_{pk}}{V_{np}}\right)$$

where $R_{est}$ is the resistance of the resonant tank equivalent resistor, $V_1$ is the reference voltage value, $\Delta t$ is the time change value, and $V_{np}$ is the negative peak voltage value; and

(d) controlling a heating power of the heating coil according to the inductance of the resonant tank equivalent inductor and the resistance of the resonant tank equivalent resistor.

In accordance with another aspect of present disclosure, a heating device is provided. The heating device includes a resonant circuit, a detection unit and a control unit. The resonant circuit includes an inverter circuit and a resonant tank. The inverter circuit provides a resonant tank current and a resonant tank voltage. The resonant tank includes a heating coil, a resonant tank capacitor, a resonant tank equivalent inductor and a resonant tank equivalent resistor. The resonant circuit includes an inverter circuit and a resonant tank. The inverter circuit provides a resonant tank current and a resonant tank voltage. The resonant tank includes a heating coil, a resonant tank capacitor, a resonant tank equivalent inductor and a resonant tank equivalent resistor. The detection unit is electrically coupled with the resonant circuit. The detection unit detects a capacitor voltage of the resonant tank capacitor to acquire a reference voltage value, a first zero-crossing time point, a second zero-crossing time point, a time change value, a resonant period and a peak voltage value. The peak voltage value includes at least one of a negative peak voltage value and a positive peak voltage value. The reference voltage value is a voltage value of the capacitor voltage when the resonant tank voltage is zero. The time change value is a time length between a time point when the resonant tank voltage is zero and the first zero-crossing time point. The resonant period is defined according to the first zero-crossing time point and the second zero-crossing time point. The control unit controls the inverter circuit to output the resonant tank current and the resonant tank voltage. Consequently, a heating power of the heating coil is adjustable.

The detection unit calculates an inductance of the resonant tank equivalent inductor according to a capacitance of the resonant tank capacitor, the resonant period and a first expression. The detection unit calculates a resistance of the resonant tank equivalent resistor according to the inductance of the resonant tank equivalent inductor, the time change value, the resonant period, the reference voltage value, the peak voltage value and one of a second expression, a third expression and a third expression. The control unit controls the heating power of the heating coil according to the inductance of the resonant tank equivalent inductor and the resistance of the resonant tank equivalent resistor. The first expression is expressed as a following mathematic formula:

$$L_{est} = \left( \frac{T}{2\pi\sqrt{C_r}} \right)^2 \quad ,$$

wherein $L_{est}$ is the inductance of the resonant tank equivalent inductor, $C_r$ is the capacitance of the resonant tank capacitor, $T$ is the resonant period, and the second expression is expressed as a following mathematic formula:

$$R_{est} = \frac{2L_{est}}{\Delta t + \frac{3T}{4}} ln \left( \frac{V_1}{V_{np}} \frac{1}{sin(\frac{\Delta t}{T}2\pi)} \right) \quad ,$$

wherein $R_{est}$ is the resistance of the resonant tank equivalent resistor, $V_1$ is the reference voltage value, $\Delta t$ is the time change value, $V_{np}$ is the negative peak voltage value, and the third expression is expressed as a following mathematic formula:

$$R_{est} = \frac{2L_{est}}{\Delta t + \frac{T}{4}} ln \left( \frac{-V_1}{V_{pk}} \frac{1}{sin(\frac{\Delta t}{T}2\pi)} \right)$$

wherein $V_{pk}$ is the positive peak voltage value, and the fourth expression is expressed as a following mathematic formula:

$$R_{est} = \frac{4L_{est}}{T} ln \left( \frac{-V_{pk}}{V_{np}} \right)$$

The above contents of the present disclosure will become more readily apparent to those ordinarily skilled in the art after reviewing the following detailed description and accompanying drawings, in which:

BRIEF DESCRIPTION OF THE DRAWINGS

FIG. 1A is a schematic functional block diagram illustrating the architecture of a heating device according to an embodiment of the present disclosure;

FIG. 1B is schematic circuit diagram illustrating the heating device as shown in FIG. 1A;

FIG. 2 is a schematic timing waveform diagram illustrating the resonant tank voltage and the capacitor voltage in the heating device of FIG. 1B;

FIG. 3 is a schematic circuit diagram illustrating the zero-crossing detection circuit in the parameter acquisition unit of the detection unit as shown in FIG. 1B;

FIG. 4 is a schematic timing waveform diagram illustrating the PWM signal from the zero-crossing detection circuit;

FIG. 5 is a schematic circuit diagram illustrating the peak value detection circuit in the parameter acquisition unit of the detection unit as shown in FIG. 1B; and

FIG. 6 is a flowchart illustrating a detecting method for a heating device according to an embodiment of the present disclosure.

## DETAILED DESCRIPTION OF THE PREFERRED EMBODIMENT

The present disclosure will now be described more specifically with reference to the following embodiments. It is to be noted that the following descriptions of preferred embodiments of this invention are presented herein for purpose of illustration and description only. It is not intended to be exhaustive or to be limited to the precise form disclosed.

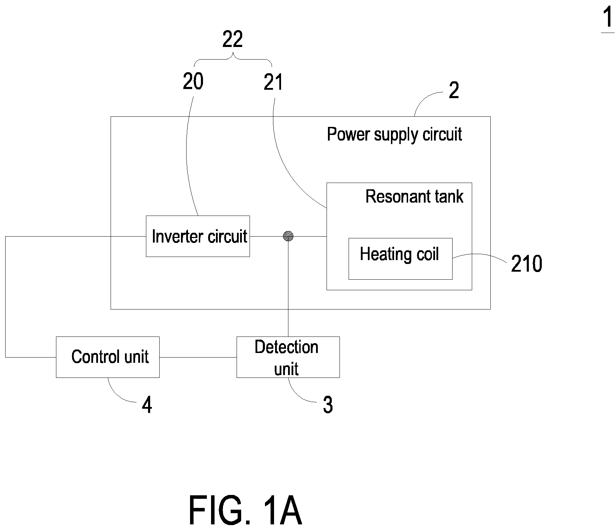

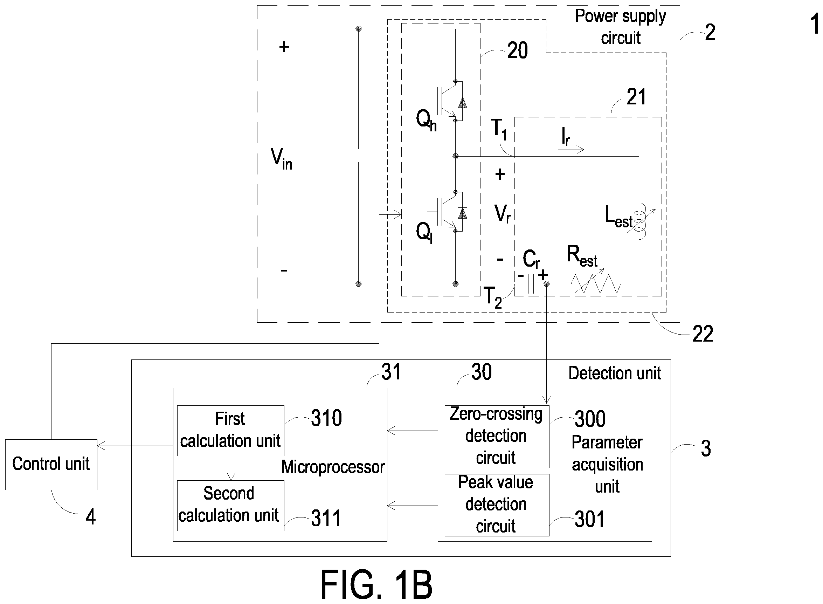

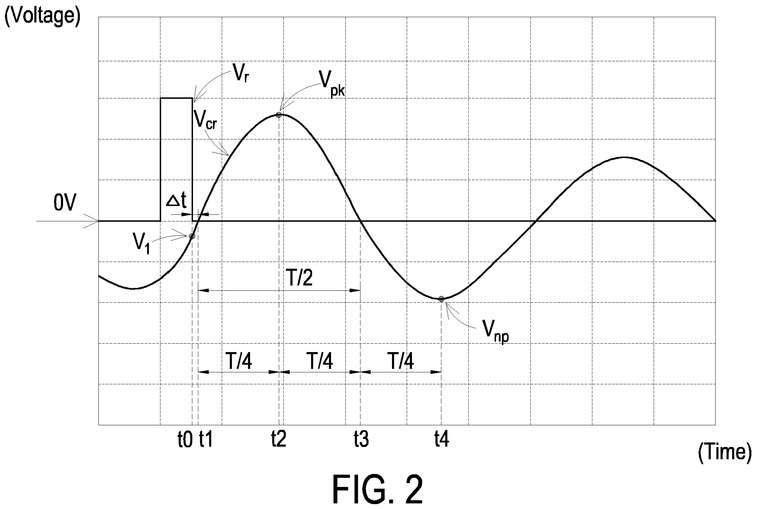

Please refer to FIGS. 1A, 1B and 2. FIG. 1A is a schematic functional block diagram illustrating the architecture of a heating device according to an embodiment of the present disclosure. FIG. 1B is schematic circuit diagram illustrating the heating device as shown in FIG. 1A. FIG. 2 is a schematic timing waveform diagram illustrating the resonant tank voltage and the capacitor voltage in the heating device of FIG. 1B. Preferably but not exclusively, the heating device 1 is an induction cooking stove. The heating device 1 includes a power supply circuit 2, a detection unit 3 and a control unit 4.

The power supply circuit 2 includes a resonant circuit 22. The resonant circuit 22 includes an inverter circuit 20 and a resonant tank 21. The inverter circuit 20 receives an input voltage $V_{in}$. The inverter circuit 20 includes at least one switch. For example, as shown in FIG. 1B, the inverter circuit 20 includes an upper switch $Q_h$ and a lower switch Qi. The upper switch $Q_h$ and the lower switch Qi are connected with each other in series. Consequently, the inverter circuit 20 is formed as a half-bridge inverter circuit. By alternately turning on and turning off the upper switch $Q_h$ and the lower switch Qi, the input voltage $V_{in}$ is converted by the inverter circuit 20. Consequently, a resonant tank current $I_r$ and a resonant tank voltage $V_r$ are outputted from the inverter circuit 20. Moreover, each of the upper switch $Q_h$ and the lower switch $Q_1$ includes a control terminal, a first conducting terminal and a second conducting terminal.

The resonant tank 21 includes a first terminal $T_1$, a second terminal Tz, a heating coil 210, a resonant tank capacitor $C_r$, a resonant tank equivalent inductor $L_{est}$ and a resonant tank equivalent resistor $R_{est}$. The first terminal $T_1$ and the second terminal $T_2$ are respectively coupled with the two conducting terminals of one of the two switches of the inverter circuit 20. As shown in FIG. 1B, the first terminal $T_1$ of the resonant tank 21 is electrically coupled with the first conducting terminal of the lower switch $Q_l$, and the second terminal $T_2$ of the resonant tank 21 is electrically coupled with the second conducting terminal of the lower switch Qi. The resonant tank capacitor $C_r$, the resonant tank equivalent inductor $L_{est}$ and the resonant tank equivalent resistor $R_{est}$ are serially connected between the first terminal $T_1$ and the second terminal $T_2$ in sequence. It is noted that the connection sequence of the resonant tank capacitor $C_r$, the resonant tank equivalent inductor $L_{est}$ and the resonant tank equivalent resistor $R_{est}$ between the first terminal $T_1$ and the second terminal $T_2$ is not restricted. The foodstuff container (not shown) on the heating device 1 is heated by heating coil 210 through induction according to the resonant tank current $I_r$ and the resonant tank voltage $V_r$ from the inverter current 20. Moreover, the resonant tank 21, the heating coil 210 and the foodstuff container are collaboratively equivalent to the resonant tank equivalent inductor $L_{est}$, and the resonant tank 21, the heating coil 210 and the foodstuff container are also equivalent to the resonant tank equivalent resistor $R_{est}$. In addition, the capacitance of the resonant tank capacitor $C_r$ is a known value.

As mentioned above, the inductance of the resonant tank equivalent inductor $L_{est}$ is related with the inductance of the heating coil 210, the material of the foodstuff container and the location of the foodstuff container on the heating device 1. In other words, when the inductance of the heating coil 210, the material of the foodstuff container or the location of the foodstuff container on the heating device 1 is changed, the inductance of the resonant tank equivalent inductor $L_{est}$ is correspondingly changed. Similarly, the resistance of the resonant tank equivalent resistor $R_{est}$ is related with the resistance of the resonant tank 21, the material of the foodstuff container and the location of the foodstuff container on the heating device 1. In other words, when the resistance of the resonant circuit 22, the material of the foodstuff container or the location of the foodstuff container on the heating device 1 is changed, the resistance of the resonant tank equivalent resistor $R_{est}$ is changed.

The control unit 4 is electrically coupled with the inverter circuit 20. The control unit 4 controls the inverter circuit 20 to output the resonant tank current $I_r$ and the resonant tank voltage $V_r$ to the resonant tank 21. Consequently, the heating power of the heating coil 210 is controlled.

The detection unit 3 is electrically coupled with the resonant circuit 22. For example, the detection unit 3 is electrically coupled with a first terminal of the resonant tank capacitor $C_r$. Moreover, the detection unit 3 detects a capacitor voltage $V_{cr}$ of the resonant tank capacitor $C_r$ to acquire the information about a reference voltage value $V_1$, a time change

value $\Delta t$, a first zero-crossing time point, a second zero-crossing time point, a resonant period T and a peak voltage value of the capacitor voltage $V_{cr}$. The peak voltage value is the maximum voltage (i.e., the positive peak voltage value $V_{pk}$) when the capacitor voltage $V_{cr}$ is positive (e.g., at the time point t2 shown in FIG. 2), or the peak voltage value is the maximum voltage (i.e., the negative peak voltage value $V_{np}$) when the capacitor voltage $V_{cr}$ is negative (e.g., at the time point t4 shown in FIG. 2). In the following example, the detection unit 3 detects the capacitor voltage $V_{cr}$ of the resonant tank capacitor $C_r$ to obtain the negative peak voltage value $V_{np}$ of the capacitor voltage $V_{cr}$.

The reference voltage value $V_1$ is the voltage value of the capacitor voltage $V_{cr}$ at the instant when the resonance tank voltage $V_r$ becomes zero. For example, when the lower switch $Q_l$ of the inverter circuit 20 is operated in the negative half cycle and switched from the off state to the on state and the resonant tank voltage $V_r$ is zero (e.g., at the time point t0), the instantaneous voltage value of the capacitor voltage $V_{cr}$ is served as the reference voltage value $V_1$. The first zero-crossing time point is the time point corresponding to the first zero value of the capacitor voltage $V_{cr}$ after the resonant tank voltage $V_r$ is zero (e.g., at the time point 11). The second zero-crossing time point is the time point corresponding to the second zero value of the capacitor voltage $V_{cr}$ after the resonant tank voltage $V_r$ is zero (e.g., at the time point t3). The time change value $\Delta t$ is a time length between the time point t0 (i.e., the time point when the resonant tank voltage $V_r$ is zero) and the time point t1 (i.e., the time point corresponding to the first zero-crossing time point). The resonant period T is defined by the first zero-crossing time point and the second zero-crossing time point. The negative peak voltage $V_{np}$ is the maximum value of the capacitor voltage $V_{cr}$ when the capacitor voltage $V_{cr}$ is negative (i.e., at the time point t4).

In an embodiment, the detection unit 3 calculates the inductance of the resonant tank equivalent inductor $L_{est}$ according to the capacitance of the resonant tank capacitor $C_r$, a first expression and the resonant period T. The first expression is expressed as the following mathematic formula (1):

$$L_{est} = \left(\frac{T}{2\pi\sqrt{C_r}}\right)^2 \text{---}(1) \; ;$$

In the above mathematic formula, $L_{est}$ is the inductance of the resonant tank equivalent inductor, $C_r$ is the capacitance of the resonant tank capacitor, and T is the resonant period.

Moreover, the detection unit 3 calculates the resistance of the resonant tank equivalent resistor $R_{est}$ according to the inductance of the resonant tank equivalent inductor $L_{est}$, the time change value $\Delta t$, the resonant period T, the reference voltage value $V_1$, the negative peak voltage value $V_{np}$ and a second expression. The second expression is expressed as the following mathematic formula (2):

$$R_{est} = \frac{2L_{est}}{\Delta t + \frac{3T}{4}} ln\left(\frac{V_1}{V_{np}} \frac{1}{sin(\frac{\Delta t}{T}2\pi)}\right) \; \text{---} (2);$$

In the above mathematic formula, $R_{est}$ is the resistance of the resonant tank equivalent resistor $R_{est}$, $V_1$ is the reference voltage value, $\Delta t$ is the time change value, and $V_{np}$ is the negative peak voltage value.

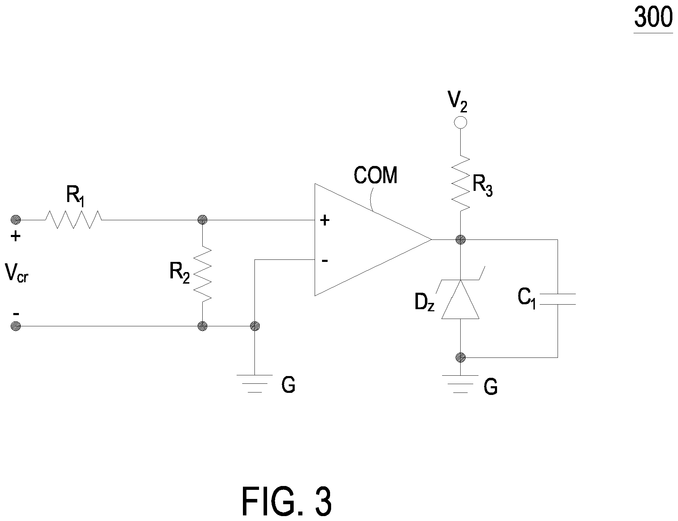

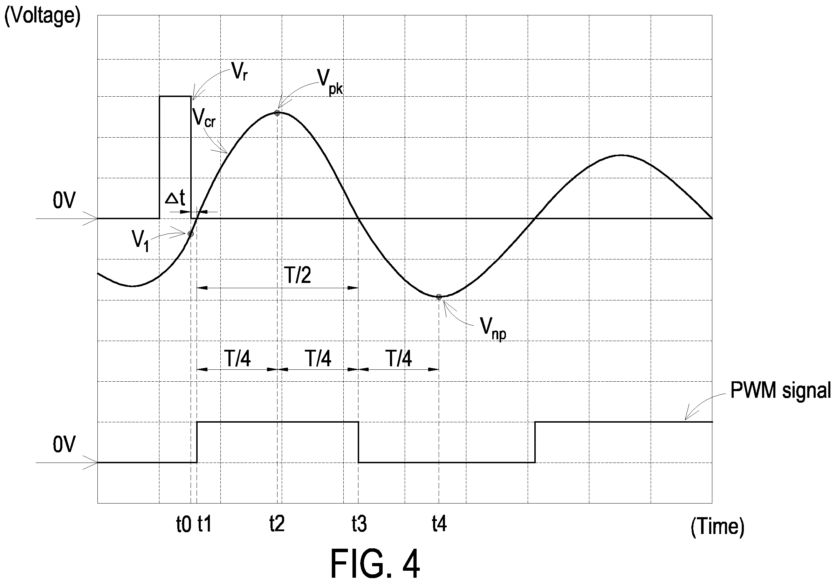

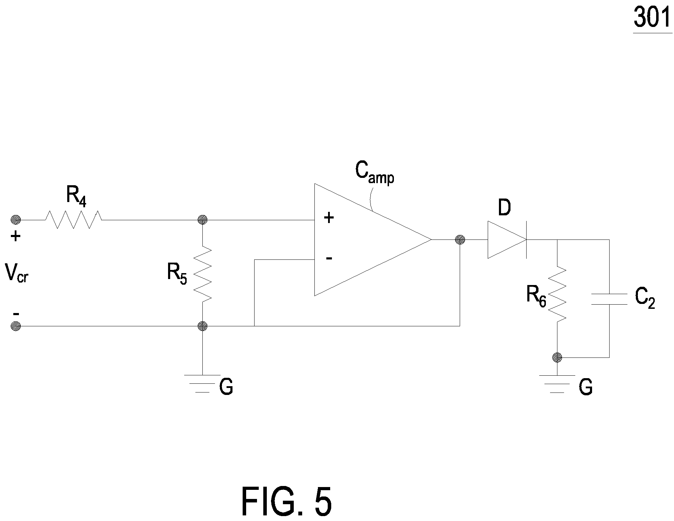

Please refer to FIGS. 1A, 1B, 2, 3, 4 and 5. FIG. 3 is a schematic circuit diagram illustrating the zero-crossing detection circuit in the parameter acquisition unit of the detection unit as shown in FIG. 1B. FIG. 4 is a schematic timing waveform diagram illustrating the PWM signal from the zero-crossing detection circuit. FIG. 5 is a schematic circuit diagram illustrating the peak value detection circuit in the parameter acquisition unit of the detection unit as shown in FIG. 1B.

The detection unit 3 includes a parameter acquisition unit 30 and a microprocessor 31. The parameter acquisition unit 30 is electrically coupled with the resonant circuit 22. For example, the parameter acquisition unit 30 is electrically coupled with the first terminal of the resonant tank capacitor $C_r$. The parameter acquisition unit 30 detects the capacitor voltage $V_{cr}$ of the resonant tank capacitor $C_r$. When the inverter circuit 20 is operated in the negative half cycle and the resonant tank voltage $V_r$ is zero (e.g., when the upper switch $Q_h$ of the inverter circuit 20 is operated in the negative half cycle and switched from the off state to the on state), the parameter acquisition unit 30 acquires the information about the resonant period T of the resonant tank 21 and the negative peak current value $V_{np}$ of the capacitor voltage $V_{cr}$ according to the capacitor voltage Ver.

The parameter acquisition unit 30 can be implemented with a hardware component or a software component. In the embodiment of FIG. 1B, the parameter acquisition unit 30 is implemented with a hardware component. In addition, the parameter acquisition unit 30 includes a zero-crossing detection circuit 300 and a peak value detection circuit 301.

The zero-crossing detection circuit 300 is electrically coupled with the resonant tank 21. For example, the zero-crossing detection circuit 300 is electrically coupled with the first terminal of the resonant tank capacitor $C_r$. The zero-crossing detection circuit 300 detects the capacitor voltage $V_{cr}$ of the resonant tank capacitor $C_r$. In addition, the zero-crossing detection circuit 300 acquires the information about the resonant period T according to the capacitor voltage $V_{cr}$ of the resonant tank capacitor $C_r$.

In an embodiment, the zero-crossing detection circuit 300 includes a first resistor $R_1$, a second resistor $R_2$, a comparator COM, a third resistor $R_3$, a first capacitor $C_1$ and a Zener diode $D_z$. The first terminal of the first resistor $R_1$ is electrically coupled with the first terminal of the resonant tank capacitor $C_r$. The first terminal of the second resistor $R_2$ is electrically connected with the second terminal of the first resistor $R_1$. In addition, the voltage across the first terminal of the first resistor $R_1$ and the second terminal of the second resistor $R_2$ is equal to the capacitor voltage $V_{cr}$. The positive input terminal of the comparator COM is electrically coupled with the second terminal of the first resistor $R_1$ and the first terminal of the second resistor $R_2$. The negative input terminal of the comparator COM is electrically coupled with the second terminal of the second resistor $R_2$ and a ground terminal G. The third resistor $R_3$ is electrically coupled between a voltage source $V_2$ (i.e., power source) and the output terminal of the comparator COM. The anode of the Zener diode $D_z$ is electrically coupled with the ground terminal G. The cathode of the Zener diode $D_z$ is electrically coupled with the output terminal of the comparator COM. The first capacitor $C_1$ is electrically connected between the output terminal of the comparator COM and the ground terminal G. In addition, the first capacitor $C_1$ and the Zener diode $D_z$ are electrically connected with each other in parallel.

Due to the hardware structure of the zero-crossing detection circuit 300, a pulse width modulation (PWM) signal is outputted from the comparator COM. Whenever the capacitor voltage $V_{cr}$ is zero (i.e., at the time point corresponding to the zero-crossing point), the PWM signal is switched from the high level state to the low level state or switched from the low level state to the high level state. After the lower switch $Q_l$ of the inverter circuit 20 is switched from the off state to the on state and the resonant tank voltage $V_r$ is zero, the time interval between the first zero-crossing time point and the second zero-crossing time point is equal to a half of the resonant period T. In other words, the resonant period T is equal to twice the time interval between the first zero-crossing time point and the second zero-crossing time point. Consequently, the resonant period T is defined by the capacitor voltage $V_{cr}$, and the zero-crossing detection circuit 300 acquires information about the resonant period T according to the capacitor voltage $V_{cr}$.

The peak value detection circuit 301 is electrically coupled with the resonant tank 21. For example, the peak value detection circuit 301 is electrically coupled with the first terminal of the resonant tank capacitor $C_r$. The peak value detection circuit 301 detects the capacitor voltage $V_{cr}$. Moreover, the peak value detection circuit 301 acquires the information about the peak voltage value (i.e., the positive peak voltage value $V_{pk}$ and/or negative peak voltage value $V_{np}$) of the capacitor voltage $V_{cr}$ according to the capacitor voltage $V_{cr}$.

In an embodiment, the peak value detection circuit 301 includes a fourth resistor $R_4$, a fifth resistor $R_5$, a sixth resistor $R_6$, a negative feedback amplifier $C_{amp}$, a diode D and a second capacitor $C_2$. The first terminal of the fourth resistor $R_4$ is electrically coupled with the first terminal of the resonant tank capacitor $C_r$. The first terminal of the fifth resistor $R_5$ is electrically connected with the second terminal of the fourth resistor $R_4$. The voltage across the first terminal of the fourth resistor $R_4$ and the second terminal of the fifth resistor $R_5$ is equal to the capacitor voltage $V_{cr}$. The non-inverting input terminal of the negative feedback amplifier $C_{amp}$ is electrically coupled with the second terminal of the fourth resistor $R_4$ and the first terminal of the fifth resistor $R_5$. The inverting input terminal of the negative feedback amplifier $C_{amp}$ is electrically coupled with the output terminal of the negative feedback amplifier $C_{amp}$. The anode of the diode D is electrically coupled with the output terminal of the negative feedback amplifier $C_{amp}$. The sixth resistor $R_6$ is electrically connected between the cathode of the diode D and the ground terminal G. The second capacitor $C_2$ is electrically connected between the cathode of the diode D and the ground terminal G. In addition, the second capacitor $C_2$ and the sixth resistor $R_6$ are electrically coupled with each other in parallel. Due to the above circuitry topology of the peak value detection circuit 301, the peak value detection circuit 301 acquires the information about the positive peak voltage value $V_{pk}$ and/ or the negative peak voltage value $V_{np}$ of the capacitor voltage $V_{cr}$ according to the capacitor voltage $V_{cr}$.

In case that the parameter acquisition unit 30 is implemented with a software component, an algorithm, a calculation formula and/or a parameter relationship table can be previously stored in the parameter acquisition unit 30. In the cooperation of the algorithm, the calculation formula and/or the parameter relationship table, the peak value detection circuit 301 acquires the information about the resonant period T, the positive peak voltage value $V_{pk}$ and/ or the negative peak voltage value $V_{np}$ of the capacitor voltage $V_{cr}$ according to the capacitor voltage $V_{cr}$.

Preferably but not exclusively, the microprocessor 31 is a digital signal processor (DSP) or a microcontroller unit (MCU). The microprocessor 31 is electrically coupled with the parameter acquisition unit 30. In an embodiment, the microprocessor 31 includes a first calculation unit 310 and a second calculation unit 311.

The first expression is previously stored in the first calculation unit 310. The first calculation unit 310 acquires the parameter information about the resonant period T from the parameter acquisition unit 30.

The first calculation unit 310 calculates the inductance of the resonant tank equivalent inductor $L_{est}$ according to the capacitance of the resonant tank capacitor $C_r$, the first expression and the received resonant period T. In addition, the first calculation unit 310 provides a first calculation result about the inductance of the resonant tank equivalent inductor Lest.

The second expression is previously stored in the second calculation unit 311. The second calculation unit 311 acquires the first calculation result about the inductance of the resonant tank equivalent inductor $L_{est}$ from the first

calculation unit 310. In addition, the second calculation unit 311 acquires the information about the reference voltage value $V_1$, the time change value $\Delta t$ and the negative peak voltage value $V_{np}$ of the capacitor voltage $V_{cr}$ according to the capacitor voltage $V_{cr}$. The second calculation unit 311 calculates the resistance of the resonant tank equivalent resistor $R_{est}$ according to the inductance of the resonant tank equivalent inductor $L_{est}$, the reference voltage value $V_1$, the time change value $\Delta t$, the negative peak voltage value $V_{np}$ of the capacitor voltage $V_{cr}$ and the second expression. In addition, the second calculation unit 311 provides a second calculation result about the resistance of the resonant tank equivalent resistor $R_{est}$.

In some embodiments, the detection unit 3 calculates the resistance of the resonant tank equivalent resistor $R_{est}$ according to the inductance of the resonant tank equivalent inductor $L_{est}$, the time change value $\Delta t$, the resonant period T, the reference voltage value $V_1$, the positive peak voltage value $V_{pk}$ and a third expression. The third expression is expressed as a following mathematic formula:

$$R_{est} = \frac{2L_{est}}{\Delta t + \frac{T}{4}} ln\left(\frac{-V_1}{V_{pk}} \frac{1}{sin(\frac{\Delta t}{T}2\pi)}\right) \quad ---(3);$$

In the above mathematic formula, $V_{pk}$ is the positive peak voltage value.

The third expression is previously stored in the second calculation unit 311. The second calculation unit 311 acquires the first calculation result about the inductance of the resonant tank equivalent inductor $L_{est}$ from the first calculation unit 310. The second calculation unit 311 acquires the information about the reference voltage value $V_1$, the time change value $\Delta t$ and the positive peak voltage value $V_{pk}$ of the capacitor voltage $V_{cr}$ according to the capacitor voltage $V_{cr}$. In addition, the second calculation unit 311 calculates the resistance of the resonant tank equivalent resistor $R_{est}$ according to the inductance of the resonant tank equivalent inductor $L_{est}$, the reference voltage value $V_1$, the time change value $\Delta t$, the positive peak voltage value $V_{pk}$ of the capacitor voltage $V_{cr}$ and the third expression. In addition, the second calculation unit 311 provides the second calculation result about the resistance of the resonant tank equivalent resistor $R_{est}$.

In some embodiments, the detection unit 3 calculates the resistance of the resonant tank equivalent resistor $R_{est}$ according to the inductance of the resonant tank equivalent inductor $L_{est}$, the time change value $\Delta t$, the resonant period T, the reference voltage value $V_1$, the negative peak voltage value $V_{np}$, the positive peak voltage value $V_{pk}$ and a fourth expression. The fourth expression is expressed as a following mathematic formula:

$$R_{est} = \frac{4L_{est}}{T} ln\left(\frac{-V_{pk}}{V_{np}}\right) \quad --- (4);$$

Moreover, the fourth expression is previously stored in the second calculation unit 311. The second calculation unit 311 acquires the first calculation result about the inductance of the resonant tank equivalent inductor $L_{est}$ from the first calculation unit 310. The second calculation unit 311 acquires the information about the reference voltage value $V_1$, the time change value $\Delta t$, the negative peak voltage value $V_{np}$ and the positive peak voltage value $V_{pk}$ of the capacitor voltage $V_{cr}$ according to the capacitor voltage $V_{cr}$. The second calculation unit 311 calculates the resistance of the resonant tank equivalent resistor $R_{est}$ according to the inductance of the resonant tank equivalent inductor $L_{est}$, the reference voltage value $V_1$, the time change value $\Delta t$, the negative peak voltage value $V_{np}$ and the positive peak voltage value $V_{pk}$ of the capacitor voltage $V_{cr}$ and the fourth expression. In addition, the second calculation unit 311 provides the second calculation result about the resistance of the resonant tank equivalent resistor $R_{est}$.

In an embodiment, the control unit 4 of the heating device 1 acquires the resonant tank equivalent inductor $L_{est}$ and the resonant tank equivalent resistor $R_{est}$ according to the first calculation result and the second calculation result from the microprocessor 31. Furthermore, the control unit 4 performs various control operations on the resonant circuit 22 according to the resonant tank equivalent inductor $L_{est}$ and the resonant tank equivalent resistor $R_{est}$. For example, according to the inductance of the resonant tank equivalent inductor $L_{est}$ and the resistance of the resonant tank equivalent resistor $R_{est}$, the control unit 4 can determine whether the heating coil 210 is enabled or disabled and determine whether the foodstuff container is placed on the heating device 1. In addition, the control unit 4 determines the burden ratio of the heating power of the heating coil 210 according to the inductance of the resonant tank equivalent inductor $L_{est}$ and the resistance of the resonant tank equivalent resistor $R_{est}$. Also, the output power from the heating device 1 is corrected by the control unit 4 in real time according to the changes of the parameter values of the resonant tank equivalent inductor $L_{est}$ and the resonant tank equivalent resistor $R_{est}$. Moreover, the control unit 4 can recognize the material of the foodstuff container according to the parameter values of the resonant tank equivalent inductor $L_{est}$ and the resonant tank equivalent resistor $R_{est}$.

Hereinafter, the first expression (1), the second expression (2), the third expression (3) and the fourth expression (4) will be roughly derived with reference to FIGS. 1A, 1B, 2 and 3.

The main working principle of the present disclosure is based on the natural response characteristics of the resonant tank 21. After the time point t=t0 (i.e., $t \geq 0$), the natural response of the resonant tank 21 occurs. Consequently, the general formula of the capacitor voltage $V_{cr}$ can be expressed as the following mathematic formula (5):

$$v_{cr}(t) = e^{-\alpha t}(B_1 \cos \omega_d t + B_2 \sin \omega_d t) \ \text{---} \ (5);$$

In the above mathematic formula, $V_{cr}(t)$ is a function of time of the capacitor voltage $V_{cr}$, $\alpha$ is an attenuation coefficient, $\omega_d$ is a damping resonance frequency, and $B_1$ and $B_2$ are arbitrary constants determined by the boundary conditions. Since the heating device 1 is an induction cooking stove, $\omega_o{}^2 >> \alpha^2$. Under this circumstance, the resonant tank 21 is operated in an underdamped zone. The damping resonance frequency can be simplified as: $\omega_d = \sqrt{\omega_o{}^2 - \alpha^2} \cong \omega_o$, where $\omega_o$ is a natural resonance frequency. Through the angle sum and difference identities, the mathematic formula (5) can be rearranged as the mathematic formula (6):

$$v_{cr}(t) = V_p e^{-\alpha t}(\sin \omega_d t + \theta) \ \text{---}(6) ;$$

In the above mathematic formula, $V_p$ is the voltage peak value when the resonant tank 21 is in the natural resonance state, and $\theta$ is the angle.

In the mathematic formula (6), some parameters may be expressed as the following general formulae:

$$\omega_o = \frac{1}{\sqrt{L_{est}C_r}} \ \text{---}(7);$$

$$\alpha = \frac{R_{est}}{2L_{est}} \ \text{---}(8);$$

Consequently, the mathematic formula (1) may be derived from the mathematic formula (7). In addition, the relationship between the resonance frequency $f_o$ and the resonant period T may be expressed as the following mathematic formula:

$$f_o = \frac{1}{T} = \frac{\omega_o}{2\pi} \ \text{---} \ (9);$$

Generally, in case that the duty cycle of the upper switch $Q_h$ is smaller, the discharge waveform of the resonant tank 21 in the negative half cycle is relatively complete. Under this circumstance, the zero-crossing detection circuit 300 can be used to obtain the half resonant period T/2. After the half resonant period T/2 is introduced into the mathematic formula (1) according to the mathematic formula (9), the first calculation unit 310 acquires the inductance of the resonant tank equivalent inductor Lest.

Moreover, the magnitude of the capacitor voltage $V_{cr}$ is zero at $\sin 0°$ and $\sin \pi$. Consequently, the zero-crossing point of the capacitor voltage $V_{cr}$ is taken as the reference point, the calculation is carried out in the form of the relative angle. Please refer to FIG. 2 again. For example, when the lower switch $Q_l$ is switched from the off state to the on state and the resonant tank voltage $V_r$ is zero (e.g., at the time point t0), the instantaneous voltage value of the capacitor voltage $V_{cr}$ is served as the reference voltage value $V_1$. That is, at the time point t0, the upper switch $Q_h$ is turned off, and the lower switch $Q_l$ is turned on. The first zero-crossing time point is the time point corresponding to the first zero value of the capacitor voltage $V_{cr}$ after the lower switch $Q_l$ is switched from the off state to the on state (e.g., at the time point 11). The time point t1 corresponds to the angle 0°. The positive peak voltage value $V_{pk}$ of the capacitor voltage $V_{cr}$ occurs at the time point t2 corresponding to the angle $\pi/2$. The negative peak voltage value $V_{np}$ of the capacitor voltage $V_{cr}$ occurs at the time point t4 corresponding to the angle $3\pi/2$. According to the mathematic formula (6), the relationship between the voltage peak value $V_P$, the positive peak voltage value $V_{pk}$, the negative peak voltage value $V_{np}$ and the angle $\theta$ may be expressed as the mathematic formulae (10), (11) and (12):

$$V_{cr} = V_P \sin(\theta) ; \ \text{t=t0} \ \text{---}(10);$$

$$V_{pk} = V_P e^{-\alpha t_1} sin(\omega_0 t_1 + \theta) = V_P e^{-\alpha t_1} \; ; \; t=t2 \; \text{---}(11);$$

$$V_{np} = V_P e^{-\alpha t_2} sin(\omega_0 t_2 + \theta) = -V_P e^{-\alpha t_2} \; ; \; t=t4 \; \text{---}(12);$$

As shown in FIG. 2, the sampling time point of the reference voltage value $V_1$ is obtained at the time point when the time change value $\Delta t$ is subtracted from the first zero-crossing time point of the capacitor voltage $V_{cr}$. Moreover, the positive peak voltage value $V_{pk}$ of the capacitor voltage $V_{cr}$ occurs at the time point t2 corresponding to the angle $\pi/2$, and the negative peak voltage value $V_{np}$ of the capacitor voltage $V_{cr}$ occurs at the time point t4 corresponding to the angle $3\pi/2$. Consequently, the following mathematic formulae (13), (14), (15), (16) and (17) can be obtained.

$$sin(\theta) = sin(0 - \frac{\Delta t}{T}2\pi) = -sin(\frac{\Delta t}{T}2\pi) \quad \text{---}(13);$$

$$sin(\omega_0 t_1 + \theta) = sin\frac{\pi}{2} = 1 \; \text{---}(14);$$

$$sin(\omega_0 t_2 + \theta) = sin\frac{3\pi}{2} = -1 \; \text{---}(15);$$

$$t_1 = \Delta t + \frac{T}{4} \; \text{---}(16);$$

$$t_2 = \Delta t + \frac{3T}{4} \; \text{---}(17);$$

The third expression for obtaining the resonant tank equivalent resistor $R_{est}$ can be derived from the mathematic formula (10) and (11).

The second expression for obtaining the resonant tank equivalent resistor $R_{est}$ can be derived from the mathematic formula (10) and (12).

The fourth expression for obtaining the resonant tank equivalent resistor $R_{est}$ can be derived from the mathematic formula (11) and (12).

As mentioned above, in case that the detection unit 3 detects the capacitor voltage $V_{cr}$ of the resonant tank capacitor $C_r$ to acquire the negative peak voltage value $V_{np}$ of the capacitor voltage $V_{cr}$, the general formula of the resonant tank equivalent resistor $R_{est}$ is the second expression (2). In case that the detection unit 3 detects the capacitor voltage $V_{cr}$ of the resonant tank capacitor $C_r$ to acquire the positive peak voltage value $V_{pk}$ of the capacitor voltage $V_{cr}$, the general formula of the resonant tank equivalent resistor $R_{est}$ is the third expression (3). In case that the detection unit 3 detects the capacitor voltage $V_{cr}$ of the resonant tank capacitor $C_r$ to acquire the positive peak voltage value $V_{pk}$ and the negative peak voltage value $V_{np}$ of the capacitor voltage $V_{cr}$, the general formula of the resonant tank equivalent resistor $R_{est}$ is the fourth expression (4).

In an embodiment, the detection unit 3 is implemented with a controller.

In the above embodiment, the inverter circuit 20 includes the upper switch $Q_h$ and the lower switch Qi. It is noted that numerous modifications and alterations may be made while retaining the teachings of the invention. In some other embodiments, the inverter circuit 20 includes a single switch or at least four switches. In case that the inverter circuit 20 includes a single switch, the first terminal $T_1$ and the second terminal $T_2$ of the resonant tank 21 are electrically connected with the first conducting terminal and the second conducting terminal of the switch, respectively. In case that the inverter circuit 20 includes four switches and the inverter circuit 20 is formed as a full-bridge inverter circuit, the first terminal $T_1$ and the second terminal $T_2$ of the resonant tank 21 are electrically coupled with the lower switch of each of the two bridge arms of the inverter circuit 20. In case that the inverter circuit 20 includes a single switch or at least four switches, the operations of the heating device are similar to the those of the heating device 1, and not redundantly described herein.

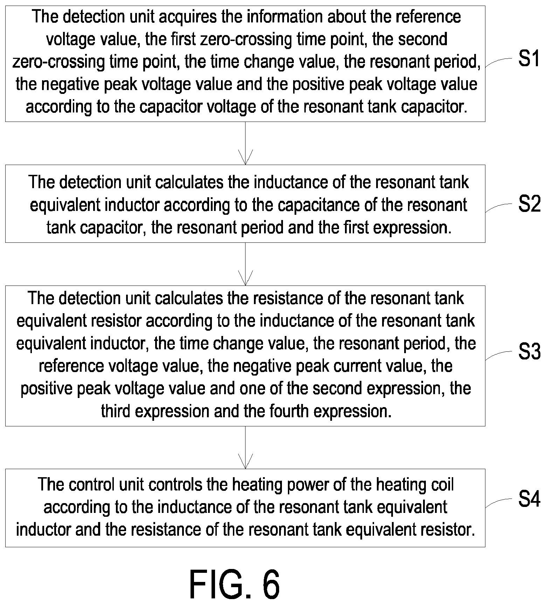

Please refer to FIG. 6. FIG. 6 is a flowchart illustrating a detecting method for a heating device according to an embodiment of the present disclosure. The detecting method is applied to the detection unit 3 of the heating device 1 as shown in FIG. 1B. The detecting method includes the following steps.

In a step S1, the detection unit 3 acquires the information about the reference voltage value $V_1$, the time change

value $\Delta t$, the first zero-crossing time point, the second zero-crossing time point, the resonant period T, the negative peak voltage value $V_{np}$ and the positive peak voltage value $V_{pk}$ according to the capacitor voltage $V_{cr}$ of the resonant tank capacitor $C_r$.

In a step S2, the detection unit 3 calculates the inductance of the resonant tank equivalent inductor $L_{est}$ according to the capacitance of the resonant tank capacitor $C_r$, the resonant period T and the first expression.

In a step S3, the detection unit 3 calculates the resistance of the resonant tank equivalent resistor $R_{est}$ according to the inductance of the resonant tank equivalent inductor $L_{est}$, the time change value $\Delta t$, the resonant period T, the reference voltage value $V_1$, the negative peak voltage value $V_{np}$, the positive peak voltage value $V_{pk}$ and one of the second expression, the third expression and the fourth expression.

In a step S4, the control unit 4 controls the heating power of the heating coil 210 according to the inductance of the resonant tank equivalent inductor $L_{est}$ and the resistance of the resonant tank equivalent resistor $R_{est}$.

Furthermore, in the step S4, the control unit 4 performs various control operations. For example, the control unit 4 determines whether the foodstuff container is placed on the heating device 1 according to the resonant tank equivalent inductor $L_{est}$ and the resonant tank equivalent resistor $R_{est}$. Moreover, the control unit 4 determines the burden ratio of the heating coil 210 according to the inductance of the resonant tank equivalent inductor $L_{est}$ and the resistance of the resonant tank equivalent resistor $R_{est}$. Moreover, the control unit 4 recognizes the material of the foodstuff container on the heating device 1 according to the inductance of the resonant tank equivalent inductor $L_{esst}$ and the resistance of the resonant tank equivalent resistor $R_{est}$.

From the above descriptions, the present disclosure provides the heating device and the detecting method for the heating device. The heating device includes the resonant tank. The main working principle of the present disclosure is based on the natural response characteristics of the resonant tank in the negative half cycle. The inductance of the resonant tank equivalent inductor is calculated according to the capacitor voltage of the resonant tank capacitor and the first expression. The resistance of the resonant tank equivalent resistor is calculated according to the inductance of the resonant tank equivalent inductor and one of the second expression, the third expression and the fourth expression. When compared with the conventional heating device, the detection circuit of the heating device of the present disclosure is simplified and the cost is reduced. Since it is not necessary to detect the current information about the resonant tank, the heating device is not equipped with the current detection circuit. In other words, the heating device of the present disclosure is cost-effective.

**Claims**

1.  A heating device (1), **characterized by** comprising:

    a resonant circuit (22) comprising an inverter circuit (20) and a resonant tank (21), wherein the inverter circuit (20) provides a resonant tank current ($I_r$) and a resonant tank voltage ($V_r$), and the resonant tank (21) comprises a heating coil (210), a resonant tank capacitor ($C_r$), a resonant tank equivalent inductor ($L_{est}$) and a resonant tank equivalent resistor ($R_{est}$);
    a detection unit (3) electrically coupled with the resonant circuit (22), wherein the detection unit (3) detects a capacitor voltage ($V_{cr}$) of the resonant tank capacitor ($C_r$) to acquire a reference voltage value ($V_1$), a first zero-crossing time point, a second zero-crossing time point, a time change value ($\Delta t$), a resonant period (T) and a negative peak current value ($V_{np}$), wherein the reference voltage value ($V_1$) is a voltage value of the capacitor voltage ($V_{cr}$) when the resonant tank voltage ($V_r$) is zero, the time change value ($\Delta t$) is a time length between a time point when the resonant tank voltage ($V_r$) is zero and the first zero-crossing time point, and the resonant period (T) is defined according to the first zero-crossing time point and the second zero-crossing time point; and
    a control unit (4) controlling the inverter circuit (20) to output the resonant tank current ($I_r$) and the resonant tank voltage ($V_r$), so that a heating power of the heating coil (210) is adjustable,
    wherein the detection unit (3) calculates an inductance of the resonant tank equivalent inductor ($L_{est}$) according to a capacitance of the resonant tank capacitor ($C_r$), the resonant period (T) and a first expression, the detection unit (3) calculates a resistance of the resonant tank equivalent resistor ($R_{est}$) according to the inductance of the resonant tank equivalent inductor ($L_{est}$), the time change value ($\Delta t$), the resonant period (T), the reference voltage value ($V_1$), the negative peak voltage value ($V_{np}$) and a second expression, and the control unit (4) controls the heating power of the heating coil (210) according to the inductance of the resonant tank equivalent inductor ($L_{est}$) and the resistance of the resonant tank equivalent resistor ($R_{est}$),
    wherein $L_{est}$ is the inductance of the resonant tank equivalent inductor ($L_{est}$), $C_r$ is the capacitance of the resonant tank capacitor ($C_r$), T is the resonant period (T), and the first expression is expressed as a following mathematic formula:

$$L_{est} = \left(\frac{T}{2\pi\sqrt{C_r}}\right)^2 \quad,$$

wherein $R_{est}$ is the resistance of the resonant tank equivalent resistor ($R_{est}$), $V_1$ is the reference voltage value ($V_1$), $\Delta t$ is the time change value ($\Delta t$), $V_{np}$ is the negative peak voltage value ($V_{np}$), and the second expression is expressed as a following mathematic formula:

$$R_{est} = \frac{2L_{est}}{\Delta t + \frac{3T}{4}} ln\left(\frac{V_1}{V_{np}} \frac{1}{sin(\frac{\Delta t}{T}2\pi)}\right) \quad.$$

2. The heating device (1) according to claim 1, wherein the detection unit (3) comprises a parameter acquisition unit (30), and the parameter acquisition unit (30) is electrically coupled with the resonant tank (21) to detect the capacitor voltage ($V_{cr}$), wherein when the resonant tank voltage ($V_r$) is zero, the parameter acquisition unit (30) acquires the resonant period (T) according to the capacitor voltage ($V_{cr}$), and the parameter acquisition unit (30) acquires the negative peak voltage value ($V_{np}$) or a positive peak voltage value ($V_{pk}$) of the capacitor voltage ($V_{cr}$) according to the capacitor voltage ($V_{cr}$).

3. The heating device (1) according to claim 2, wherein the parameter acquisition unit (30) comprises:

   a zero-crossing detection circuit (300) electrically coupled with the resonant tank (21), wherein the zero-crossing detection circuit (300) detects the capacitor voltage ($V_{cr}$), and the zero-crossing detection circuit (300) acquires the resonant period (T) according to the capacitor voltage ($V_{cr}$); and
   a peak value detection circuit (301) electrically coupled with the resonant tank (21), wherein the peak value detection circuit (301) detects the capacitor voltage ($V_{cr}$), and the peak value detection circuit (301) acquires the negative peak voltage value ($V_{np}$) or the positive peak voltage value ($V_{pk}$) according to the capacitor voltage ($V_{cr}$).

4. The heating device (1) according to claim 3, wherein the zero-crossing detection circuit (300) comprises:

   a first resistor ($R_1$), wherein a first terminal of the first resistor ($R_1$) is electrically coupled with a first terminal of the resonant tank capacitor ($C_r$);
   a second resistor ($R_2$), wherein a first terminal of the second resistor ($R_2$) is electrically connected with a second terminal of the first resistor ($R_1$), and a voltage difference between the first terminal of the first resistor ($R_1$) and a second terminal of the second resistor ($R_2$) is equal to the capacitor voltage ($V_{cr}$);
   a comparator (COM), wherein a positive input terminal of the comparator (COM) is electrically coupled with the second terminal of the first resistor ($R_1$) and the first terminal of the second resistor ($R_2$), and a negative input terminal of the comparator (COM) is electrically coupled with the second terminal of the second resistor ($R_2$) and a ground terminal (G);
   a third resistor ($R_3$) electrically connected between a power source ($V_2$) and an output terminal of the comparator (COM);
   a Zener diode ($D_z$), wherein an anode of the Zener diode ($D_z$) is electrically coupled with the ground terminal (G), and a cathode of the Zener diode ($D_z$) is electrically coupled with the output terminal of the comparator (COM); and
   a first capacitor ($C_1$) electrically connected between the output terminal of the comparator (COM) and the ground terminal (G), wherein the first capacitor ($C_1$) and the Zener diode ($D_z$) are electrically connected with each other in parallel.

5. The heating device (1) according to claim 3, wherein the peak value detection circuit (301) comprises:

   a fourth resistor ($R_4$), wherein a first terminal of the fourth resistor ($R_4$) is electrically coupled with a first terminal of the resonant tank capacitor (Cr);
   a fifth resistor ($R_5$), wherein a first terminal of the fifth resistor ($R_5$) is electrically connected with a second terminal of the fourth resistor ($R_4$), and a voltage difference between the first terminal of the fourth resistor ($R_4$) and a second terminal of the fifth resistor ($R_5$) is equal to the capacitor voltage ($V_{cr}$);
   a negative feedback amplifier ($C_{amp}$), wherein a non-inverting input terminal of the negative feedback amplifier ($C_{amp}$) is electrically coupled with the second terminal of the fourth resistor ($R_4$) and the first terminal of the fifth resistor ($R_5$), and an inverting input terminal of the negative feedback amplifier ($C_{amp}$) is electrically coupled with an output terminal of the negative feedback amplifier ($C_{amp}$);

a diode (D), wherein an anode of the diode (D) is electrically coupled with the output terminal of the negative feedback amplifier ($C_{amp}$);

a sixth resistor ($R_6$) electrically connected between a cathode of the diode (D) and a ground terminal (G); and

a second capacitor ($C_2$) electrically connected between the cathode of the diode (D) and the ground terminal (G), wherein the second capacitor ($C_2$) and the sixth resistor ($R_6$) are electrically connected with each other in parallel.

6. The heating device (1) according to claim 4, wherein the detection unit (3) further comprises a microprocessor (31), and the microprocessor (31) comprises:

a first calculation unit (310), wherein the first expression is previously stored in the first calculation unit (310), and the first calculation unit (310) calculates the inductance of the resonant tank equivalent inductor ($L_{est}$) according to the capacitance of the resonant tank capacitor ($C_r$), the resonant period (T) provided by the zero-crossing detection circuit (300) and the first expression, and the first calculation unit (310) provides a first calculation result to the control unit (4); and

a second calculation unit (320), wherein the second expression is previously stored in the second calculation unit (320), the second calculation unit (320) acquires the first calculation result from the first calculation unit (310), the second calculation unit (320) acquires the reference voltage value ($V_1$), the time change value ($\Delta t$) and the negative peak voltage value ($V_{np}$) of the capacitor voltage ($V_{cr}$) according to the capacitor voltage ($V_{cr}$), the second calculation unit (320) calculates the resistance of the resonant tank equivalent resistor ($R_{est}$) according to the inductance of the resonant tank equivalent inductor ($L_{est}$), the reference voltage value ($V_1$), the time change value ($\Delta t$), the negative peak voltage value ($V_{np}$) of the capacitor voltage ($V_{cr}$) and the second expression, and the second calculation unit (320) provides a second calculation result to the control unit (4).

7. The heating device (1) according to claim 6, wherein the microprocessor (31) is a digital signal processor or a microcontroller unit.

8. The heating device (1) according to claim 1, wherein the heating device (1) is an induction cooking stove.

9. The heating device (1) according to claim 1, wherein the inverter circuit (20) comprises an upper switch ($Q_h$) and a lower switch ($Q_1$), which are connected with each other in series, wherein the upper switch ($Q_h$) and the lower switch ($Q_1$) are alternately turned on and turned off, and a first terminal and a second terminal of the resonant tank (21) are respectively coupled with two conducting terminals of the lower switch ($Q_1$).

10. A detecting method for a detection unit (3) of a heating device (1), the heating device (1) further comprising a resonant circuit (22), the resonant circuit (22) comprising an inverter circuit (20) and a resonant tank (21), the inverter circuit (20) providing a resonant tank current ($I_r$) and a resonant tank voltage ($V_r$), the resonant tank (21) comprising a heating coil (210), a resonant tank capacitor ($C_r$), a resonant tank equivalent inductor ($L_{est}$) and a resonant tank equivalent resistor ($R_{est}$), **characterized in that** the detecting method comprises steps of:

(a) detecting a capacitor voltage ($V_{cr}$) of the resonant tank capacitor ($C_r$) to acquire a reference voltage value ($V_1$), a first zero-crossing time point, a second zero-crossing time point, a time change value ($\Delta t$), a resonant period (T), a negative peak voltage value ($V_{np}$) and a positive peak voltage value ($V_{pk}$), wherein the reference voltage value ($V_1$) is a voltage value of the capacitor voltage ($V_{cr}$) when the resonant tank voltage ($V_r$) is zero, the time change value ($\Delta t$) is a time length between a time point when the resonant tank voltage ($V_r$) is zero and the first zero-crossing time point, and the resonant period (T) is defined according to the first zero-crossing time point and the second zero-crossing time point;

(b) calculating an inductance of the resonant tank equivalent inductor ($L_{est}$) according to a capacitance of the resonant tank capacitor ($C_r$), the resonant period (T) and a first expression, wherein the first expression is expressed as a following mathematic formula:

$$L_{est} = \left(\frac{T}{2\pi\sqrt{C_r}}\right)^2 \quad ,$$

where $L_{est}$ is the inductance of the resonant tank equivalent inductor ($L_{est}$), $C_r$ is the capacitance of the resonant tank capacitor ($C_r$), and T is the resonant period (T);

(c) calculating a resistance of the resonant tank equivalent resistor ($R_{est}$) according to the inductance of the resonant tank equivalent inductor ($L_{est}$), the time change value ($\Delta t$), the resonant period (T), the reference voltage

value ($V_1$), the negative peak voltage value ($V_{np}$), the positive peak voltage value ($V_{pk}$) and one of a second expression, a third expression and a fourth expression, wherein the second expression is expressed as a following mathematic formula:

$$R_{est} = \frac{2L_{est}}{\Delta t + \frac{3T}{4}} ln\left(\frac{V_1}{V_{np}} \frac{1}{sin(\frac{\Delta t}{T}2\pi)}\right) \quad ,$$

the third expression is expressed as a following mathematic formula:

$$R_{est} = \frac{2L_{est}}{\Delta t + \frac{T}{4}} ln\left(\frac{-V_1}{V_{pk}} \frac{1}{sin(\frac{\Delta t}{T}2\pi)}\right)$$

the fourth expression is expressed as a following mathematic formula:

$$R_{est} = \frac{4L_{est}}{T} ln\left(\frac{-V_{pk}}{V_{np}}\right)$$

where $R_{est}$ is the resistance of the resonant tank equivalent resistor ($R_{est}$), $V_1$ is the reference voltage value ($V_1$), $\Delta t$ is the time change value ($\Delta t$), and $V_{np}$ is the negative peak voltage value ($V_{np}$); and
(d) controlling a heating power of the heating coil (210) according to the inductance of the resonant tank equivalent inductor ($L_{est}$) and the resistance of the resonant tank equivalent resistor ($R_{est}$).

11. The detecting method according to claim 10, wherein the heating device (1) is an induction cooking stove, and the step (d) further comprises a step of determining whether a foodstuff container is placed on the heating device (1) according to the inductance of the resonant tank equivalent inductor ($L_{est}$) and the resistance of the resonant tank equivalent resistor ($R_{est}$).

12. The detecting method according to claim 10, wherein the heating device (1) is an induction cooking stove, and the step (d) further comprises a step of determining a burden ratio of the heating coil (210) according to the inductance of the resonant tank equivalent inductor ($L_{est}$) and the resistance of the resonant tank equivalent resistor ($R_{est}$).

13. The detecting method according to claim 10, wherein the heating device (1) is an induction cooking stove, and the step (d) further comprises a step of recognizing a material of a foodstuff container on the heating device (1) according to the inductance of the resonant tank equivalent inductor ($L_{est}$) and the resistance of the resonant tank equivalent resistor ($R_{est}$).

14. A heating device (1), **characterized by** comprising:

a resonant circuit (22) comprising an inverter circuit (20) and a resonant tank (21), wherein the inverter circuit (20) provides a resonant tank current ($I_r$) and a resonant tank voltage ($V_r$), and the resonant tank (21) comprises a heating coil (210), a resonant tank capacitor ($C_r$), a resonant tank equivalent inductor ($L_{est}$) and a resonant tank equivalent resistor ($R_{est}$);
a detection unit (3) electrically coupled with the resonant circuit (22), wherein the detection unit (3) detects a capacitor voltage ($V_{cr}$) of the resonant tank capacitor ($C_r$) to acquire a reference voltage value ($V_1$), a first zero-crossing time point, a second zero-crossing time point, a time change value ($\Delta t$), a resonant period (T) and a peak voltage value, wherein the peak voltage value includes at least one of a negative peak voltage value ($V_{np}$) and a positive peak voltage value ($V_{pk}$), the reference voltage value is a voltage value of the capacitor voltage ($V_{cr}$) when the resonant tank voltage ($V_r$) is zero, the time change value ($\Delta t$) is a time length between a time point when the resonant tank voltage ($V_r$) is zero and the first zero-crossing time point, and the resonant period (T) is defined according to the first zero-crossing time point and the second zero-crossing time point; and
a control unit (4) controlling the inverter circuit (20) to output the resonant tank current ($I_r$) and the resonant tank voltage ($V_r$), so that a heating power of the heating coil (210) is adjustable,
wherein the detection unit (3) calculates an inductance of the resonant tank equivalent inductor ($L_{est}$) according to a capacitance of the resonant tank capacitor ($C_r$), the resonant period (T) and a first expression, the detection unit (3) calculates a resistance of the resonant tank equivalent resistor ($R_{est}$) according to the inductance of the resonant tank equivalent inductor ($L_{est}$), the time change value ($\Delta t$), the resonant period (T), the reference voltage value ($V_1$), the peak voltage value and one of a second expression, a third expression and a third expression, and the control unit (4) controls the heating power of the heating coil (210) according to the inductance of the resonant tank equivalent inductor ($L_{est}$) and the resistance of the resonant tank equivalent resistor ($R_{est}$),

wherein $L_{est}$ is the inductance of the resonant tank equivalent inductor ($L_{est}$), $C_r$ is the capacitance of the resonant tank capacitor ($C_r$), T is the resonant period (T), and the first expression is expressed as a following mathematic formula:

$$L_{est} = \left(\frac{T}{2\pi\sqrt{C_r}}\right)^2 \quad ,$$

wherein $R_{est}$ is the resistance of the resonant tank equivalent resistor ($R_{est}$), $V_1$ is the reference voltage value ($V_1$), $\Delta t$ is the time change value ($\Delta t$), $V_{np}$ is the negative peak voltage value ($V_{np}$), and the second expression is expressed as a following mathematic formula:

$$R_{est} = \frac{2L_{est}}{\Delta t + \frac{3T}{4}} ln\left(\frac{V_1}{V_{np}} \frac{1}{sin(\frac{\Delta t}{T}2\pi)}\right) \quad ,$$

wherein $V_{pk}$ is the positive peak voltage value ($V_{pk}$), and the third expression is expressed as a following mathematic formula:

$$R_{est} = \frac{2L_{est}}{\Delta t + \frac{T}{4}} ln\left(\frac{-V_1}{V_{pk}} \frac{1}{sin(\frac{\Delta t}{T}2\pi)}\right) \quad ,$$

wherein $V_{pk}$ is the positive peak voltage value ($V_{pk}$), $V_{np}$ is the negative peak voltage value ($V_{np}$), and the fourth expression is expressed as a following mathematic formula:

$$R_{est} = \frac{4L_{est}}{T} ln\left(\frac{-V_{pk}}{V_{np}}\right)$$

**Amended claims in accordance with Rule 137(2) EPC.**

1. A detecting method for a detection unit (3) of a heating device (1), the heating device (1) further comprising a resonant circuit (22), the resonant circuit (22) comprising an inverter circuit (20) and a resonant tank (21), the inverter circuit (20) providing a resonant tank current ($I_r$) and a resonant tank voltage ($V_r$), the resonant tank (21) comprising a heating coil (210), a resonant tank capacitor ($C_r$), a resonant tank equivalent inductor ($L_{est}$) and a resonant tank equivalent resistor ($R_{est}$), the detecting method comprises steps of:

    (a) detecting a capacitor voltage ($V_{cr}$) of the resonant tank capacitor ($C_r$) to acquire a reference voltage value ($V_1$), a first zero-crossing time point for the capacitor voltage ($V_{cr}$), a second zero-crossing time point for the capacitor voltage ($V_{cr}$), a time change value ($\Delta t$), a resonant period (T), a negative peak voltage value ($V_{np}$) and a positive peak voltage value ($V_{pk}$), wherein the reference voltage value ($V_1$) is a voltage value of the capacitor voltage ($V_{cr}$) when the resonant tank voltage ($V_r$) is zero, the time change value ($\Delta t$) is a time length between a time point when the resonant tank voltage ($V_r$) is zero and the first zero-crossing time point, and the resonant period (T) is defined according to the first zero-crossing time point and the second zero-crossing time point;

    **characterized in that** the detecting method comprises steps of:

    (b) calculating an inductance of the resonant tank equivalent inductor ($L_{est}$) according to a capacitance of the resonant tank capacitor ($C_r$), the resonant period (T) and a first expression, wherein the first expression is expressed as a following mathematic formula:

$$L_{est} = \left(\frac{T}{2\pi\sqrt{C_r}}\right)^2 \quad,$$

where $L_{est}$ is the inductance of the resonant tank equivalent inductor ($L_{est}$), $C_r$ is the capacitance of the resonant tank capacitor ($C_r$), and T is the resonant period (T);

(c) calculating a resistance of the resonant tank equivalent resistor ($R_{est}$) according to the inductance of the resonant tank equivalent inductor ($L_{est}$), the time change value ($\Delta t$), the resonant period (T), the reference voltage value ($V_1$), the negative peak voltage value ($V_{np}$), the positive peak voltage value ($V_{pk}$) and one of a second expression, a third expression and a fourth expression, wherein the second expression is expressed as a following mathematic formula:

$$R_{est} = \frac{2L_{est}}{\Delta t + \frac{3T}{4}} ln\left(\frac{V_1}{V_{np}} \frac{1}{sin(\frac{\Delta t}{T}2\pi)}\right) \quad,$$

the third expression is expressed as a following mathematic formula:

$$R_{est} = \frac{2L_{est}}{\Delta t + \frac{T}{4}} ln\left(\frac{-V_1}{V_{pk}} \frac{1}{sin(\frac{\Delta t}{T}2\pi)}\right)$$

the fourth expression is expressed as a following mathematic formula:

$$R_{est} = \frac{4L_{est}}{T} ln\left(\frac{-V_{pk}}{V_{np}}\right)$$

where $R_{est}$ is the resistance of the resonant tank equivalent resistor ($R_{est}$), $V_1$ is the reference voltage value ($V_1$), $\Delta t$ is the time change value ($\Delta t$), and $V_{np}$ is the negative peak voltage value ($V_{np}$); and

(d) controlling a heating power of the heating coil (210) according to the inductance of the resonant tank equivalent inductor ($L_{est}$) and the resistance of the resonant tank equivalent resistor ($R_{est}$).

2. The detecting method according to claim 1, wherein the heating device (1) is an induction cooking stove, and the step (d) further comprises a step of determining whether a foodstuff container is placed on the heating device (1) according to the inductance of the resonant tank equivalent inductor ($L_{est}$) and the resistance of the resonant tank equivalent resistor ($R_{est}$).

3. The detecting method according to claim 1, wherein the heating device (1) is an induction cooking stove, and the step (d) further comprises a step of determining a burden ratio of the heating coil (210) according to the inductance of the resonant tank equivalent inductor ($L_{est}$) and the resistance of the resonant tank equivalent resistor ($R_{est}$).

4. The detecting method according to claim 1, wherein the heating device (1) is an induction cooking stove, and the step (d) further comprises a step of recognizing a material of a foodstuff container on the heating device (1) according to the inductance of the resonant tank equivalent inductor ($L_{est}$) and the resistance of the resonant tank equivalent resistor ($R_{est}$).

5. A heating device (1), comprising:

a resonant circuit (22) comprising an inverter circuit (20) and a resonant tank (21), wherein the inverter circuit (20) provides a resonant tank current ($I_r$) and a resonant tank voltage ($V_r$), and the resonant tank (21) comprises a heating coil (210), a resonant tank capacitor ($C_r$), a resonant tank equivalent inductor ($L_{est}$) and a resonant tank equivalent resistor ($R_{est}$);

a detection unit (3) electrically coupled with the resonant circuit (22), wherein the detection unit (3) detects a capacitor voltage ($V_{cr}$) of the resonant tank capacitor ($C_r$) to acquire a reference voltage value ($V_1$), a first zero-crossing time point for the capacitor voltage ($V_{cr}$), a second zero-crossing time point for the capacitor voltage ($V_{cr}$), a time change value ($\Delta t$), a resonant period (T) and a peak voltage value, wherein the peak voltage value includes at least one of a negative peak voltage value ($V_{np}$) and a positive peak voltage value ($V_{pk}$), the reference voltage value is a voltage value of the capacitor voltage ($V_{cr}$) when the resonant tank voltage ($V_r$) is zero, the time

change value ($\Delta t$) is a time length between a time point when the resonant tank voltage ($V_r$) is zero and the first zero-crossing time point, and the resonant period (T) is defined according to the first zero-crossing time point and the second zero-crossing time point; and

a control unit (4) controlling the inverter circuit (20) to output the resonant tank current ($I_r$) and the resonant tank voltage ($V_r$), so that a heating power of the heating coil (210) is adjustable,

**characterized in that** the detection unit (3) calculates an inductance of the resonant tank equivalent inductor ($L_{est}$) according to a capacitance of the resonant tank capacitor ($C_r$), the resonant period (T) and a first expression, the detection unit (3) calculates a resistance of the resonant tank equivalent resistor ($R_{est}$) according to the inductance of the resonant tank equivalent inductor ($L_{est}$), the time change value ($\Delta t$), the resonant period (T), the reference voltage value ($V_1$), the peak voltage value and one of a second expression, a third expression and a fourth expression, and the control unit (4) controls the heating power of the heating coil (210) according to the inductance of the resonant tank equivalent inductor ($L_{est}$) and the resistance of the resonant tank equivalent resistor ($R_{est}$),

wherein $L_{est}$ is the inductance of the resonant tank equivalent inductor ($L_{est}$), $C_r$ is the capacitance of the resonant tank capacitor ($C_r$), T is the resonant period (T), and the first expression is expressed as a following mathematic formula:

$$L_{est} = \left(\frac{T}{2\pi\sqrt{C_r}}\right)^2 \quad ,$$

wherein $R_{est}$ is the resistance of the resonant tank equivalent resistor ($R_{est}$), $V_1$ is the reference voltage value ($V_1$), $\Delta t$ is the time change value ($\Delta t$), $V_{np}$ is the negative peak voltage value ($V_{np}$), and the second expression is expressed as a following mathematic formula:

$$R_{est} = \frac{2L_{est}}{\Delta t + \frac{3T}{4}} ln\left(\frac{V_1}{V_{np}} \frac{1}{sin(\frac{\Delta t}{T}2\pi)}\right) \quad ,$$

wherein $V_{pk}$ is the positive peak voltage value ($V_{pk}$), and the third expression is expressed as a following mathematic formula:

$$R_{est} = \frac{2L_{est}}{\Delta t + \frac{T}{4}} ln\left(\frac{-V_1}{V_{pk}} \frac{1}{sin(\frac{\Delta t}{T}2\pi)}\right) \quad ,$$

wherein $V_{pk}$ is the positive peak voltage value ($V_{pk}$), $V_{np}$ is the negative peak voltage value ($V_{np}$), and the fourth expression is expressed as a following mathematic formula:

$$R_{est} = \frac{4L_{est}}{T} ln\left(\frac{-V_{pk}}{V_{np}}\right)$$

.

6. The heating device (1) according to claim 5, wherein the detection unit (3) comprises a parameter acquisition unit (30), and the parameter acquisition unit (30) is electrically coupled with the resonant tank (21) to detect the capacitor voltage ($V_{cr}$), wherein when the resonant tank voltage ($V_r$) is zero, the parameter acquisition unit (30) acquires the resonant period (T) according to the capacitor voltage ($V_{cr}$), and the parameter acquisition unit (30) acquires the negative peak voltage value ($V_{np}$) or a positive peak voltage value ($V_{pk}$) of the capacitor voltage ($V_{cr}$) according to the capacitor voltage ($V_{cr}$).

7. The heating device (1) according to claim 6, wherein the parameter acquisition unit (30) comprises:

a zero-crossing detection circuit (300) electrically coupled with the resonant tank (21), wherein the zero-crossing detection circuit (300) detects the capacitor voltage ($V_{cr}$), and the zero-crossing detection circuit (300) acquires the resonant period (T) according to the capacitor voltage ($V_{cr}$); and

a peak value detection circuit (301) electrically coupled with the resonant tank (21), wherein the peak value detection circuit (301) detects the capacitor voltage ($V_{cr}$), and the peak value detection circuit (301) acquires the negative peak voltage value ($V_{np}$) or the positive peak voltage value ($V_{pk}$) according to the capacitor voltage ($V_{cr}$).

8. The heating device (1) according to claim 7, wherein the zero-crossing detection circuit (300) comprises:

a first resistor ($R_1$), wherein a first terminal of the first resistor ($R_1$) is electrically coupled with a first terminal of the resonant tank capacitor ($C_r$);

a second resistor ($R_2$), wherein a first terminal of the second resistor ($R_2$) is electrically connected with a second terminal of the first resistor ($R_1$), and a voltage difference between the first terminal of the first resistor ($R_1$) and a second terminal of the second resistor ($R_2$) is equal to the capacitor voltage (Vcr);

a comparator (COM), wherein a positive input terminal of the comparator (COM) is electrically coupled with the second terminal of the first resistor ($R_1$) and the first terminal of the second resistor ($R_2$), and a negative input terminal of the comparator (COM) is electrically coupled with the second terminal of the second resistor ($R_2$) and a ground terminal (G);

a third resistor ($R_3$) electrically connected between a power source ($V_2$) and an output terminal of the comparator (COM);

a Zener diode ($D_z$), wherein an anode of the Zener diode ($D_z$) is electrically coupled with the ground terminal (G), and a cathode of the Zener diode ($D_z$) is electrically coupled with the output terminal of the comparator (COM); and

a first capacitor ($C_1$) electrically connected between the output terminal of the comparator (COM) and the ground terminal (G), wherein the first capacitor ($C_1$) and the Zener diode ($D_z$) are electrically connected with each other in parallel.

9. The heating device (1) according to claim 7, wherein the peak value detection circuit (301) comprises:

a fourth resistor ($R_4$), wherein a first terminal of the fourth resistor ($R_4$) is electrically coupled with a first terminal of the resonant tank capacitor ($C_r$);

a fifth resistor ($R_5$), wherein a first terminal of the fifth resistor ($R_5$) is electrically connected with a second terminal of the fourth resistor ($R_4$), and a voltage difference between the first terminal of the fourth resistor ($R_4$) and a second terminal of the fifth resistor ($R_5$) is equal to the capacitor voltage ($V_{cr}$);

a negative feedback amplifier ($C_{amp}$), wherein a non-inverting input terminal of the negative feedback amplifier ($C_{amp}$) is electrically coupled with the second terminal of the fourth resistor ($R_4$) and the first terminal of the fifth resistor ($R_5$), and an inverting input terminal of the negative feedback amplifier ($C_{amp}$) is electrically coupled with an output terminal of the negative feedback amplifier ($C_{amp}$);

a diode (D), wherein an anode of the diode (D) is electrically coupled with the output terminal of the negative feedback amplifier ($C_{amp}$);

a sixth resistor ($R_6$) electrically connected between a cathode of the diode (D) and a ground terminal (G); and

a second capacitor ($C_2$) electrically connected between the cathode of the diode (D) and the ground terminal (G), wherein the second capacitor ($C_2$) and the sixth resistor ($R_6$) are electrically connected with each other in parallel.

10. The heating device (1) according to claim 8, wherein the detection unit (3) further comprises a microprocessor (31), and the microprocessor (31) comprises:

a first calculation unit (310), wherein the first expression is previously stored in the first calculation unit (310), and the first calculation unit (310) calculates the inductance of the resonant tank equivalent inductor ($L_{est}$) according to the capacitance of the resonant tank capacitor ($C_r$), the resonant period (T) provided by the zero-crossing detection circuit (300) and the first expression, and the first calculation unit (310) provides a first calculation result to the control unit (4); and

a second calculation unit (320), wherein the second expression is previously stored in the second calculation unit (320), the second calculation unit (320) acquires the first calculation result from the first calculation unit (310), the second calculation unit (320) acquires the reference voltage value ($V_1$), the time change value ($\Delta t$) and the negative peak voltage value ($V_{np}$) of the capacitor voltage ($V_{cr}$) according to the capacitor voltage ($V_{cr}$), the second calculation unit (320) calculates the resistance of the resonant tank equivalent resistor ($R_{est}$) according to the inductance of the resonant tank equivalent inductor ($L_{est}$), the reference voltage value ($V_1$), the time change value ($\Delta t$), the negative peak voltage value ($V_{np}$) of the capacitor voltage ($V_{cr}$) and the second expression, and the second calculation unit (320) provides a second calculation result to the control unit (4).

11. The heating device (1) according to claim 10, wherein the microprocessor (31) is a digital signal processor or a microcontroller unit.

12. The heating device (1) according to claim 5, wherein the heating device (1) is an induction cooking stove.

13. The heating device (1) according to claim 5, wherein the inverter circuit (20) comprises an upper switch ($Q_h$) and a lower switch ($Q_l$), which are connected with each other in series, wherein the upper switch ($Q_h$) and the lower switch ($Q_l$) are alternately turned on and turned off, and a first terminal and a second terminal of the resonant tank (21) are respectively coupled with two conducting terminals of the lower switch ($Q_l$).

FIG. 1A

Power supply circuit  2

Resonant tank  21

Heating coil  210

Inverter circuit  20

22

Detection unit  3

Control unit  4

1

FIG. 1B

FIG. 2

FIG. 3

FIG. 4

301

FIG. 5

The detection unit acquires the information about the reference voltage value, the first zero-crossing time point, the second zero-crossing time point, the time change value, the resonant period, the negative peak voltage value and the positive peak voltage value according to the capacitor voltage of the resonant tank capacitor. — S1

The detection unit calculates the inductance of the resonant tank equivalent inductor according to the capacitance of the resonant tank capacitor, the resonant period and the first expression. — S2

The detection unit calculates the resistance of the resonant tank equivalent resistor according to the inductance of the resonant tank equivalent inductor, the time change value, the resonant period, the reference voltage value, the negative peak current value, the positive peak voltage value and one of the second expression, the third expression and the fourth expression. — S3

The control unit controls the heating power of the heating coil according to the inductance of the resonant tank equivalent inductor and the resistance of the resonant tank equivalent resistor. — S4

FIG. 6

Europäisches Patentamt

European Patent Office

Office européen des brevets

# EUROPEAN SEARCH REPORT

**Application Number**

EP 24 15 1391

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 4 207 944 A1 (DELTA ELECTRONICS INC [TW]) 5 July 2023 (2023-07-05)<br>* paragraph [0001] *<br>* paragraph [0006] *<br>* paragraph [0011] - paragraph [0016]; figures 1A-1B * | 1-14 | INV.<br>H05B6/06 |
| | - - - - - | | |
| Y | EP 2 437 573 A1 (MITSUBISHI ELECTRIC CORP [JP]; MITSUBISHI ELECTRIC HOME APPL [JP]) 4 April 2012 (2012-04-04)<br>* paragraph [0001] *<br>* paragraph [0029] - paragraph [0030]; figure 1 *<br>* paragraph [0049]; figure 6 * | 1-14 | |
| | - - - - - | | |

**TECHNICAL FIELDS SEARCHED (IPC)**

H05B

The present search report has been drawn up for all claims

| Place of search | Date of completion of the search | Examiner |
|---|---|---|
| Munich | 20 June 2024 | Barzic, Florent |

EPO FORM 1503 03.82 (P04C01)

**ANNEX TO THE EUROPEAN SEARCH REPORT
ON EUROPEAN PATENT APPLICATION NO.**

EP 24 15 1391

This annex lists the patent family members relating to the patent documents cited in the above-mentioned European search report.
The members are as contained in the European Patent Office EDP file on
The European Patent Office is in no way liable for these particulars which are merely given for the purpose of information.

20-06-2024

| Patent document cited in search report | | Publication date | Patent family member(s) | | Publication date |
|---|---|---|---|---|---|
| EP 4207944 | A1 | 05-07-2023 | CN | 116419442 A | 11-07-2023 |
| | | | EP | 4207944 A1 | 05-07-2023 |
| | | | US | 2023217551 A1 | 06-07-2023 |
| EP 2437573 | A1 | 04-04-2012 | CN | 102428750 A | 25-04-2012 |
| | | | EP | 2437573 A1 | 04-04-2012 |
| | | | ES | 2557329 T3 | 25-01-2016 |
| | | | JP | 5225465 B2 | 03-07-2013 |
| | | | JP | WO2010137498 A1 | 15-11-2012 |
| | | | WO | 2010137498 A1 | 02-12-2010 |

EPO FORM P0459

For more details about this annex : see Official Journal of the European Patent Office, No. 12/82